# EUROPEAN PATENT SPECIFICATION

(11) **EP 3 355 348 B1**
(45) Date of publication and mention of the grant of the patent: **23.06.2021**
(21) Application number: 17153301.1
(22) Date of filing: 26.01.2017
(51) Int. Cl.: H01L 23/495

(54) **METHOD FOR MANUFACTURING A SEMICONDUCTOR PACKAGE**
VERFAHREN ZUR HERSTELLUNG EINES HALBLEITERGEHÄUSES
PROCÉDÉ DE FABRICATION D'UN DISPOSITIF SEMI-CONDUCTEUR

(43) Date of publication of application: 01.08.2018
(73) Proprietor: Sensirion AG, 8712 Stäfa (CH)
(72) Inventor: Böller, Matthias, 8712 Stäfa (CH); Brugger, Thomas, 8712 Stäfa (CH); Braun, Stephan, 8712 Stäfa (CH)
(74) Representative: Toleti, Martin

(56) References cited:
- EP-A1- 2 952 886
- WO-A1-2009/125250
- US-A1- 2011 201 159
- US-A1- 2013 302 945

## Description

### Field of the Invention

The present invention relates to a method for manufacturing a semiconductor package.

### Technical Background

Semiconductor chips are mostly packaged by some encapsulation. In this respect, the semiconductor chip is arranged on and electrically connected to a leadframe which resulting leadframe assembly is at least partly encapsulated. Portions of the leadframe exposed from the encapsulation may serve as contact pads for electrically connecting the semiconductor chip during operation.

However, a leadframe typically is made from a material susceptible to corrosion, such as copper. Hence, it is preferred that the leadframe is plated with a material less susceptible to corrosion. However, plating a leadframe up-front, i.e. as a whole, has the disadvantage that any cuts in the leadframe required during manufacturing will result in un-plated surfaces that are susceptible to corrosion during the lifetime of the package, in particular when these surfaces are exposed from the encapsulation.

WO 2009/125250 A1 describes an integrated circuit package including a cover formed from a body, the cover having a side where the cover has been separated from another part of the body. A die is at least partially covered by the cover. A lead is electrically connected to at least a part of the die, the lead having at least one exposed surface at the side, the exposed surface being provided with a surface protection layer which protects the exposed surface against oxidation, the surface protection layer being made of solderable material.

US 2011/201159 A1 describes a semiconductor package comprising: terminals electrically connected to a semiconductor device; a resin for sealing a part of the terminals and the device; an electrolytic plating layer of Ag, Sn, or Ni being formed on each of bottom surfaces of the terminals partly projecting from the resin; an electroless plating layer of Ni, Sn, Ag, Ag/Au, Ni/Au, Ni/Ag, Ni/Pd/Au, or Ni/Pd/Ag being formed thereon; and an electroless plating layer comprising the same material as the electroless plating layer previously formed on the bottom surface of the protruding terminal being formed on each lateral surfaces of the protruding terminals. This configuration enables a lead frame material to be etched from its bottom surface to separate the terminals from each other, thereby preventing corrosion due to oxidation of the lateral surfaces (standoff sides) of the terminals exposed by the etching, and further reducing a total manufacturing cost.

US 2013/302945 A1 describes a method of dividing a two dimensional array of encapsulated integrated circuits into individual integrated circuit packages using a first series of parallel cuts extending fully through the leadframe and encapsulation layer, and defining rows of the array. The cuts terminate before the beginning and end of the rows such that the integrity of the array is maintained by edge portions at the ends of the rows. After plating contact pads, a second series of parallel cuts is made extending fully through the leadframe and encapsulation layer. This separates the array into columns thereby providing singulation of packages between the edge portions.

EP 2 952 886 A1 describes a method for manufacturing a gas sensor package, comprising the steps of mounting a semiconductor chip on a carrier and applying a mold compound for at least partially enclosing the semiconductor chip thereby generating an opening in the mold compound, wherein the opening provides access to a portion of the semiconductor chip being uncovered by the mold compound. After molding, a sensitive material is applied through the opening onto the uncovered portion of the semiconductor chip for building a layer sensitive to a gas.

### Disclosure of the Invention

A method for manufacturing semiconductor packages comprises the step of providing an electrically conducting leadframe. The leadframe has a front side and a back side and comprises multiple die pads, at least one set of contact pads, and a support lead connected to the contact pads of the set. A semiconductor chip is mounted on each die pad resulting in a leadframe assembly which is at least partly encapsulated. After providing the encapsulation, the support lead is separated from the contact pads of the set thereby generating an exposed side face of each contact pad of the set. Only then, a plating process is applied to the encapsulated leadframe assembly resulting in semiconductor packages having contact pads with at least a plated side face.

The plating process is an electroless plating process in which no electrical potential needs to be applied to the element to be plated. This is desirable in the present context given that at the time of plating it is preferred that the contact pads are already electrically isolated. The supply of an electrical potential to each of the contact pads for plating purposes is not considered as practical in mass fabrication. In electroless plating instead, the required difference of potential between the element to be plated and the material to plate with is provided by the materials themselves when selected properly. However, in conventional electroless plating, surfaces to be plated require a preprocessing in order to enable the plating. Such preprocessing requires the application of a so-called activator to the subject surfaces, which in one example may be PbCl₂. However, such activator is not selective for the material of the leadframe. Hence, uncontrolled deposition of the metal to be plated such as Ni on other parts of the semiconductor package, such as on an encapsulation, was found to be a problem, since these other parts were found to be activated for plating by the activator substance.

Instead, the electroless plating process as presently applied requires no activator applied to the element to be plated. In the present electroless plating process, which is an activator-free plating process, the semiconductor package is directly immersed into a bath containing the plating material without requiring a prior immersion into a bath containing an activator. Preferably, the semiconductor packages are immersed into the respective bath/s as a whole including the encapsulation. However, given that no activator is required in this kind of plating process, no nonselective activator material needs to be used. Silver as first plating material is selective to e.g. copper as leadframe material, and hence only plates on copper but not on the encapsulation. The subsequent plating material gold is selective to silver but not to the encapsulation material either, such that no uncontrolled silver or gold deposition occurs on the encapsulation, i.e. the mold compound. Finally, in contrast to pre-dicing desired for electroplating - i.e. only partially separating the support lead from the contact pads for granting a continued electrical connection between the contact pads for subsequent electroplating -, the complete side face of each contact pad is plated and as such can serve as wetting surface for contact material as a whole given that only a plated surface provides suitable wetting properties for the contact material to electrically contact the semiconductor package to a carrier. In addition, and not less important, the plated surface protects the contact pad from corrosion. With the present approach the entire side surface of a contact pad is plated and hence protected from corrosion.

Hence, in a first step, the singulated semiconductor packages are immersed into a bath comprising silver ions resulting in a silver plating on the exposed metal / leadframe surfaces of the semiconductor packages, and especially on any exposed surfaces of the contact pads, and preferably on any exposed surfaces of the leadframe. Subsequently, the resulting semiconductor packages, now showing at least side faces and preferably back sides of the contact pads plated with silver, are immersed into a bath comprising gold ions resulting in a gold plating on top of the silver plating. Preferably, in a preparation step prior to the above first step, a copper etching step is applied for removing oxidized copper from the exposed surfaces of the contact pads.

No plating material deposits on the encapsulation, since no activator is required that may make elements other than the desired ones susceptible to plating. The subject plating process is also referred to as ISIG plating process (Immersion Silver Immersion Gold). For the plating technology, it is referred to "Nickel-free final finishes in the electronics industry", Andres Gross, Norbert Sitte, published in Microelectronics Packaging Conference (EMPC), 2015, retrieved and accessed on the internet under http://ieeexplore.ieee.org/document/7390712/ on January 10, 2017, the content of which publication is introduced by reference. In the final finish, a semi-autocatalytic gold electrolyte is used to enhance the processing of the resulting surface metallizations which exhibit an excellent soldering and bonding performance. This plating method is based on a chemical exchange process between the material of the leadframe, in particular copper, and the silver, respectively the silver and gold.

The result are semiconductor packages having contact pads plated with a silver plating and a gold plating on top of the silver plating, portions of which contact pads would otherwise remain un-plated even when the leadframe initially were plated as a whole since the singulation / separation of the semiconductor packages exposes new un-plated surfaces, i.e. at least the above side faces of the contact pads that would otherwise be sensitive to corrosion.

However, in the present final semiconductor packages any exposed surfaces of the contact pads show a plating, especially a silver plating on top of the material of the leadframe and a gold plating on top of the silver plating. The exposed surfaces of the contact pads first include the side faces generated by separating the contact pads from the support lead/s. Those side surfaces cannot be plated upfront since they are generated during manufacturing. Preferably, other surfaces of the contact pads may be exposed from the encapsulation in addition to the side surfaces, in particular the back side of each contact pad which is exposed on purpose from the encapsulation, i.a. by designing the mould accordingly, as representing the preferred place to apply contact material to for electrically connecting the semiconductor package to a carrier. While those back sides of the contact pads - as well as any other surfaces of the leadframe exposed from the encapsulation - may generally be already covered by a plating in case the entire leadframe is plated in a pre-fabrication step, those surfaces including the back sides of the contact pads are once more plated during the suggested silver and gold plating process. Even in case the leadframe would be provided un-plated, such surfaces are plated after the suggested processing.

Finally, electroplating is avoided such that the contact pads can electrically be isolated from each other prior to plating. This has the advantage that when separating the semiconductor packages from each other, leadframe structures can fully be cut without the need for pre-cuts which are desired in electroplating in order to electrically connect the various leadframe portions to be plated and supply energy to only a single spot of the leadframe. Accordingly, exposed leadframe portions are generated during manufacturing, i.e. the side faces of the contact pads, in the separation step. These side faces are fully plated allowing the contact material, such as solder, to wet and cover the complete side face. An electrical contact extending all across the side face in turn can be optically inspected and, if present, allows for the assumption of a sustainable electrical contact between the subject contact pad and a metallization of a carrier the semiconductor chip is mounted to.

Accordingly, the present idea not only provides high-quality and long-lasting contact pads in view of corrosion or other aging effects, but at the same time allows cutting the leadframe during manufacturing and have the resulting faces afterwards fully plated without the drawbacks described for electroplating and electroless plating including activators. Avoiding the latter results in the encapsulation remaining free from any plating residuals in view no activator encouraging the plating material to plate on the encapsulation.

The leadframe is an electrically conducting leadframe which is understood as an electrically conducting structure of leads and / or pads made out of metal, for example copper, by punching or etching a metal sheet. A die pad is a portion of the leadframe offering a footprint sufficient for attaching a semiconductor chip to. The contact pads of the set are connected to a common support lead. The set, for example, may include all contact pads arranged in a row at one side of the semiconductor package to be built, or only some of. Multiple sets may be provided, each with an assigned support lead such that typically a set includes all contact pads arranged in a row supported by the same support lead.

Preferably, the support lead has a longitudinal extension orthogonal to a longitudinal extension of the contact pads. Typically, the contact pads are arranged in a row facing an edge of the die pad, and, in the final semiconductor package are separated from the support lead and remain as individual contact pads electrically isolated from each other. In the final semiconductor package, each contact pad may serve for electrically contacting the semiconductor package to the outside. In the leadframe, a contact pad may solely be connected to the support lead, or may also be connected to the die pad in case of accepting the potential of the die pad.

The leadframe has a front side and a back side, wherein typically portions of the back side are exposed from the final semiconductor package, either serving as electrical contacts, or serving as heat sink as may be the case with the die pad. In an embodiment, the leadframe may have recessed portions in its back side, which recessed portions may finally not be exposed from the encapsulation but remain embedded therein. In this respect, a contact pad may show both, a recessed portion and an exposed portion.

Preferably, the die pad has a rectangular shape with four edges, wherein the set of contact pads preferably is arranged facing a first edge of the die pad. Preferably, another set of contact pads is provided which contact pads face a second edge of the die pad opposite the first edge. The contact pads of this other set are connected to another common support lead. Further sets of contact pads may be arranged facing the other two edges of the die pad, each set being connected to a dedicated support lead. The rectangular die pad may also have a sloped corner, and still be considered as rectangle having four edges. Hence, Dual Flat No Leads (DFN) or Quad Flat No Leads (QFN) packages may be manufactured. Instead of a QFN package, one or more leads may extend from the die pad at these other two edges not facing contact pads but connected to support leads for holding the die pad.

Multiple semiconductor packages are manufactured in the same processing steps thereby making use of a leadframe onto which multiple semiconductor chips are be placed. Such leadframe comprises a die pad per semiconductor chip. Multiple die pads may be provided per semiconductor package in case other chips shall be arranged in the package, such as an ASIC, etc. In another embodiment, more than one semiconductor chip can be arranged on a common die pad. Preferably, electrical connections are established between each semiconductor chip and corresponding contact pads, such as by means of bond wires. This arrangement is also referred to as leadframe assembly.

A common support lead is provided for two sets of contact pads belonging to adjacent die pads, and hence to adjacent semiconductor packages to be built. It is preferred, that the contact pads of the two sets terminate in the support lead at the same longitudinal position of the support lead.

In another step, each semiconductor chip is at least partly encapsulated by means of a molding compound which preferably belongs to the group of epoxy based polymers with filler particles which filler particles e.g. may be glass, and specifically SiO₂. For doing so, the leadframe is arranged in a mold. Specifically, the mold may comprise a bottom mold onto which the leadframe is set with its back side. A top mold may, together with the bottom mold contribute to the mold between which top and bottom mold the leadframe assembly is arranged in. The top mold may comprise a projection integrated or attached thereto, per semiconductor chip. The semiconductor chip is a sensor chip comprising a sensing element which requires access to the environment for appropriate sensing.

The mold compound is applied into the mold for generating an arrangement comprising at least a partial encapsulation of the semiconductor chip.

In the resulting arrangement, i.e. the encapsulated leadframe assembly, representing multiple semiconductor packages, the / each support lead is removed by severing from the assigned contact pads. Preferably, this is achieved in a common severing step also referred to as separation step, preferably by means of a linear severing tool such as a saw or a punch cutting all contact pads to the same length. The separating step results in electrically isolating the contact pads of the set from each other. The separating step in one embodiment includes sawing the encapsulated leadframe assembly. The sawing may be executed along the longitudinal extension of the support lead by means of a blade. In a preferred embodiment, a width of the blade exceeds a width of the support lead resulting in a complete removal of the support lead and in a cutting of each contact pad. In case contact pads of two sets belong to adjacent semiconductor packages, a single cutting operation may separate each of the resulting semiconductor packages from the support lead and from each other.

The mold allows for a common encapsulation of all semiconductor chips on the leadframe. In this case, the mold compound is allowed to deposit on the one or more support leads and on all the contact pads. The sawing then is applied through the encapsulation and the contact pads, preferably from a back side of the arrangement, i.e. sawing through the leadframe first and through the encapsulation thereafter.

In a different embodiment, the separation step may include punching the leadframe with a punch instead of sawing with a blade. In this case, it is preferred that the encapsulation does not extend onto the one or more support leads but terminates prior to. The mold is designed accordingly, and has projections to separate the encapsulations of the individual semiconductor packages such that the individual semiconductor packages are linked at this stage by the leadframe only, and specifically by the support leads. The punching then does not require punching through any mold compound.

Prior to separating the support lead/s from the contact pads, the encapsulated leadframe assembly is arranged on a dicing tape which may be considered as any type of support that is suitable for supporting the subsequent dicing operation, and which preferably is a film. The encapsulated leadframe assembly is arranged on the dicing tape with its front side facing the dicing tape and its back side facing away from the dicing tape. Note that the back side of the encapsulated leadframe assembly is defined as side comprising the exposed back sides of the contact pads, while the front side of the encapsulated leadframe assembly is opposite. Accordingly, the encapsulated leadframe assembly sits on the dicing tape with the encapsulation, and the access openings facing the dicing tape. Accordingly, in this position, any sensing elements accessible via the access openings are protected during dicing. The semiconductor packages - which at this point in time are still connected by leads and by the common encapsulation - are separated from each other by applying a separation tool from the back side of the encapsulated leadframe assembly.

In addition, given that exposed surfaces of the contact pads will be plated in this arrangement on the dicing tape or a different support, any plating steps such as the immersion into a bath do not affect the semiconductor chips, and in particular do not affect any sensing element via the according access opening in the encapsulation since the access opening faces the subject dicing tape or support. Accordingly, no chemical substances may enter the access opening during plating.

In the separation step, the encapsulated leadframe assembly preferably is cut or punched. As a result, the semiconductor packages previously connected by the leadframe and the encapsulation are separated.

Then, the above described plating process is applied to the semiconductor packages in common when still attached to the dicing tape.

In another embodiment, instead of using a single cutting tool with a defined width for performing the complete cut in one go down to the dicing tape, a first cutting tool with a first width may be used for separating the support lead from the contact pads. However, this first cutting does not cut through the entire encapsulation. The suggested plating is then applied. Only after plating, a second cutting tool may be applied showing a second width less than the first width, which second cutting tool is used to cut through the remaining encapsulation down to at least the dicing tape.

In the different embodiment including separation by punching, the leadframe assembly including the individually encapsulated semiconductor chips preferably is punched from a front side of the assembly and hence from the front side of the leadframe. For this purpose, the assembly may be arranged on a tape with the backside of the leadframe facing the tape. After punching, the individual semiconductor packages preferably are removed from the tape if any, and are arranged on a support, now with the front side of each semiconductor package and hence any access opening facing the support. This assembly then is plated by immersion into the respective baths.

After plating, the / each semiconductor package preferably is picked from the support. Such semiconductor package preferably only includes plated contact pads. Thereafter, or after shipping the semiconductor packages, a semiconductor package may be mounted onto a carrier. The carrier may be a printed circuit board or any other carrier. For electrically connecting, contact material such as solder preferably is placed on metallizations of the carrier the back sides of the contact pads of the semiconductor package shall be contacted to. Preferably, a metallization exceeds the contact pad in size which excess area preferably is uncovered by the semiconductor package after placement on the carrier. The entire metallization area is covered by the contact material. By means of placing and pressing the semiconductor package onto / against the carrier, the contact material wets the back side of each contact pad, and contact material provided at the excess portion of the metallization may creep along the plated side surface and completely wet.

In some scenarios, the wetting of the side face with contact material may not only prove a sufficient electrical contact but may even increase the surface of the contact pad to be wetted by the contact material, in particular in case of small scale contact pads, where it is important to generate a sufficient wetting surface.

In any case, the resulting electrical contact at the side face preferably is optically inspected in particular from top of the semiconductor package or at least from the side. The inspection can in particular be performed automatically, or in a different embodiment by a person.

The present disclosure provides a method for manufacturing multiple semiconductor packages according to claim 1.

Other advantageous embodiments are listed in the dependent claims.

### Brief Description of the Drawings

Embodiments of the present invention, aspects and advantages will become apparent from the following detailed description thereof. Such description makes reference to the annexed drawings, wherein the figures show:
Figs. 1 to 4 diagrams illustrating steps of a method for manufacturing a semiconductor package according to an embodiment of the present invention;
Fig. 5 a side cut of a contact pad of a semiconductor package according to an embodiment of the present invention;
Figs. 6 to 10 diagrams illustrating steps of a method for manufacturing multiple semiconductor packages according to an embodiment of the present invention;
Fig. 11 a diagram illustrating an alternative step to the step illustrated in Fig. 7 not falling under the present invention.

### Detailed Description of the Drawings

All embodiments shown in the Figures may be applicable to the manufacturing of QFN as well as DFN packages.

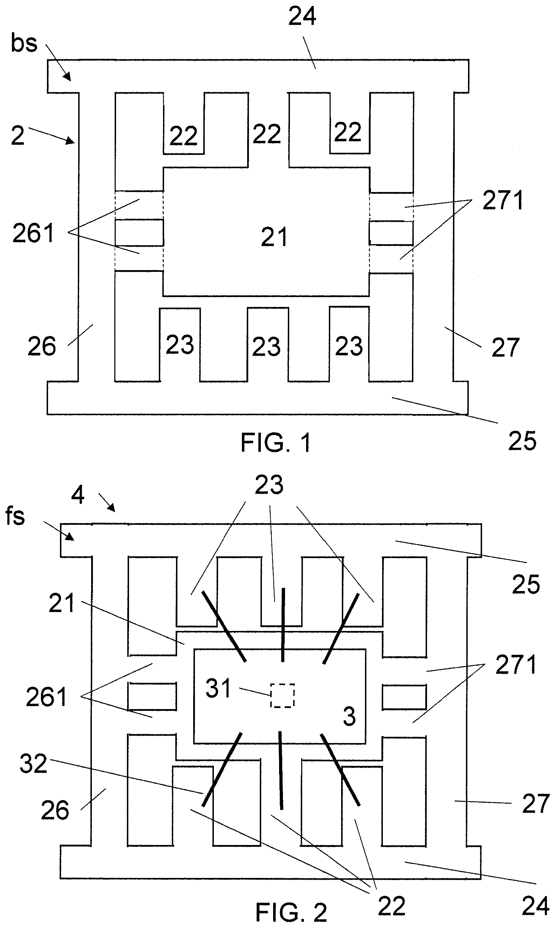

Figures 1 to 4 illustrate steps of a method for manufacturing a semiconductor package according to an embodiment of the present invention.

FIG. 1 illustrates an example of a leadframe 2 provided, e.g. from its back side bs. A leadframe typically is a grid like structure made from an electrically conducting material. The individual interconnected leads may be etched or punched from a thin sheet of metal, such as copper. It is assumed, that the present leadframe 2 already is prepared into a shape as shown in FIG. 1 for the purpose of manufacturing a semiconductor package from. The present leadframe 2 contains, for example, horizontal support leads 24 and 25 and vertical support leads 26 and 27. The leadframe 2 further comprises a die pad 21 serving as a platform to mount a semiconductor chip on. The die pad 21 is connected to the vertical support leads 26, 27 by means of leads 261 and 271. The dashed lines defining the leads 261 and 271 indicate, that in the present example, these leads 261 and 271 are thinned from the back side bs, and e.g. are only half as thick as the remaining portions of the leadframe 2. This feature however, is optional. The thinning can be achieved during the preparation of the leadframe 2, e.g. by etching.

The horizontal support leads 24 and 25 contain finger like extensions, which represent contact pads 22 and 23 of the future semiconductor package. The contact pads 22 constitute a set with each contact pad 22 of this set facing the die pad 21 from a first side. Actually, in the present example, the contact pad 22 in the middle is connected to the die pad 21 and hence serves as ground connection. The contact pads 23 constitute another set with each contact pad 23 of this other set facing the die pad 21 from a second side opposite the first side. It is understood, that the overall number of contact pads 22, 23, the allocation of contact pads 22, 23 with respect to the die pad 21, and the geometry of the die pad 21 may vary. The layout of the leadframe 2 may vary subject to the application. The leadframe 2 as provided in FIG. 1 in one embodiment is not plated against corrosion, and in a different embodiment is completely plated against corrosion.

Figure 2 shows a flipped view on the leadframe 2 of Figure 1, i.e. a view on its front side fs: A semiconductor chip 3 is mounted on the front side fs of the die pad 21, e.g. by bonding or gluing. The semiconductor chip 3 may in one embodiment be electrically connected to the contact pads 22 and 23 by means of bond wires 32. The resulting arrangement is referred to as leadframe assembly 4.

The semiconductor chip 3 is a sensor chip containing a sensing element indicated by 31, and preferably contains integrated circuitry for processing signals supplied from the sensing element 31. The semiconductor chip 3 may be prepared from a wafer and the circuitry if any may be integrated on wafer-level. The sensor element 31 may be integrated on wafer-level, too, or be applied onto a surface of the semiconductor chip 3 later on. The semiconductor chip 3 may also be further prepared e.g. by manufacturing a recess in the back side of the semiconductor chip, e.g. on wafer-level.

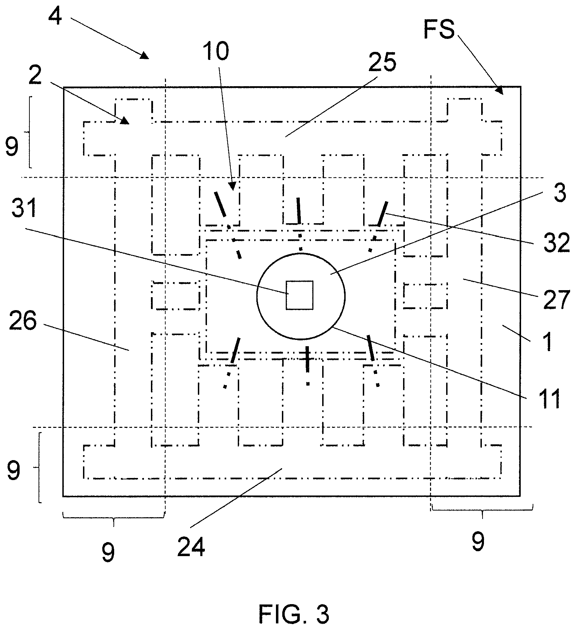

In a further step, the arrangement containing the leadframe 2 and the semiconductor chip 3 - which arrangement is also referred to as leadframe assembly 4 - is arranged in a mold and a molding compound is applied into the mold. As a result, the leadframe assembly 4 now comprises an encapsulation 1 fully or partly encapsulating the semiconductor chip 3 and partially encapsulating the leadframe 2. Figure 3 shows a view on a front side FS of the encapsulated leadframe assembly 4 and hence on the front side FS of the future semiconductor package which front side primarily includes the encapsulation 1 leaving an access opening 11 for granting access to the sensing element 31.

The leadframe 2 and the semiconductor chip 3 are illustrated in a phantom view, covered by the encapsulation 1. The dashed lines in Figure 3 indicate sawing streets 9 by which the support leads 24 - 27 including the enclosing encapsulation 1 are separated from what remains as semiconductor package 10. After sawing side faces of the contact pads 22, 23 and of leads 261, 271, i.e. all cut faces, remain exposed and un-plated.

The resulting semiconductor package 10 is shown in a perspective view in diagram 4a), and in a bottom view on its back side BS in diagram 4b). As can be derived from diagrams 4a) and 4b), a back side bs of each contact pad 22, 23 is exposed from the encapsulation 1 at the back side BS of the semiconductor package 10 while at the same time a side face sf of each contact pad 22, 23 is exposed from the encapsulation 1 in a side wall of the semiconductor package 10. In the present example, in addition to the contact pads 22 and 23, the back side bs of the die pad 21 is also exposed from the encapsulation 1. Side faces of the leads 271 (and 261 not shown) are also exposed from side walls of the semiconductor package, however, distant from a bottom of the semiconductor package 10 in view of the thinning of the leads in this section, see Figure 1.

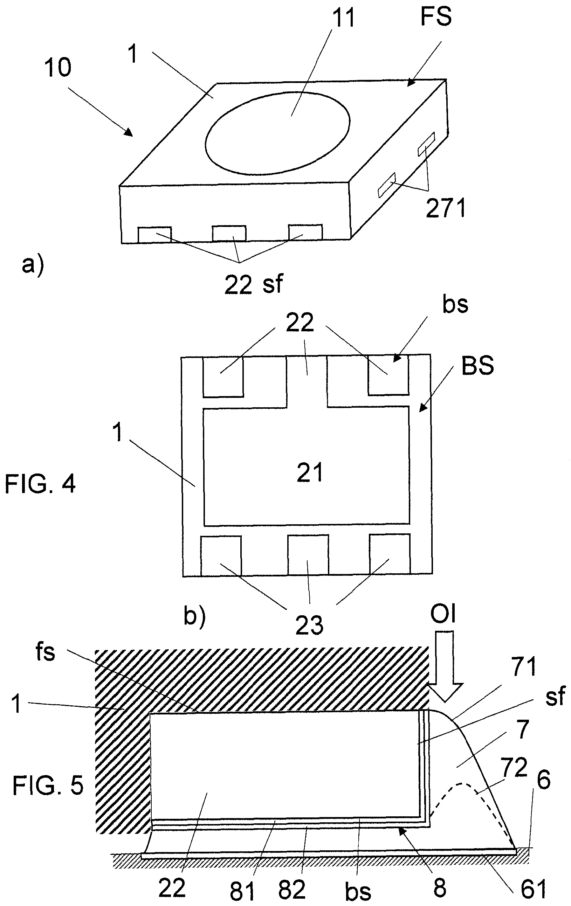

In another step, the semiconductor package 10 of Figure 4 is plated in an ISIG (Immersion Silver Immersion Gold) plating process. Figure 5 refers to an enlarged side cut of a contact pad 22 of the semiconductor package 10 of FIG. 4 after plating, and after having the semiconductor package 10 surface mounted onto a carrier 6, according to an embodiment of the present invention. In this example, the present contact pad 22 is encapsulated at its front side fs and at some of its side faces, while its back side bs and the side face sf that was generated by cutting the support lead 24 are exposed from the encapsulation 1. The plating is indicated by reference 8, and specifically comprises a silver plating 81 covering the leadframe material, and a gold plating 82 covering the silver plating 81. The plating 8 hence covers only the back side bs and the side face sf of the contact pad 22 as depicted but not any other surfaces since the plating is applied after fabricating the encapsulation 1. In case the leadframe is pre-plated as a whole, the plating 8 at the back-side may cover such preplating while the plating 8 at the side face sf covers the leadframe material in any case.

The carrier 6 may be a printed circuit board as is shown in FIG. 5. The printed circuit board is prefabricated by metallizations, such as the metallization 61. The metallization 61 exceeds the size of the contact pad 22, and preferably exceeds the size of the contact pad 22 in a direction that remains uncovered by the semiconductor package 10. The metallization 61 is covered across its entire area by contact material 7. For example, the contact material 7 in form of solder may be applied to the metallization 61 uniformly in height, e.g. by applying a mask. In a next step, when allocating the semiconductor package 10 onto the carrier 6, the back side bs of the contact pad 22 is wetted by the contact material 7 as is shown in FIG. 5. The contact material 7 provided on the excess portion of the metallization 61 creeps along the plated side face of the contact pad 22. Ideally, the electrical contact 71 finally wets the side face completely as is shown in FIG. 5. In this case, the shape of the electrical contact 71 at the side face sf of the contact pad 22 allows for a reliable optical inspection of the contact from the top as is indicated by arrow OI. In a less successful wetting, the electrical contact may have a shape as indicated by reference numeral 72 also indicated by a dashed line. Such electrical contact 72 would also be identified by optical inspection OI and be distinguished from electrical contact 71.

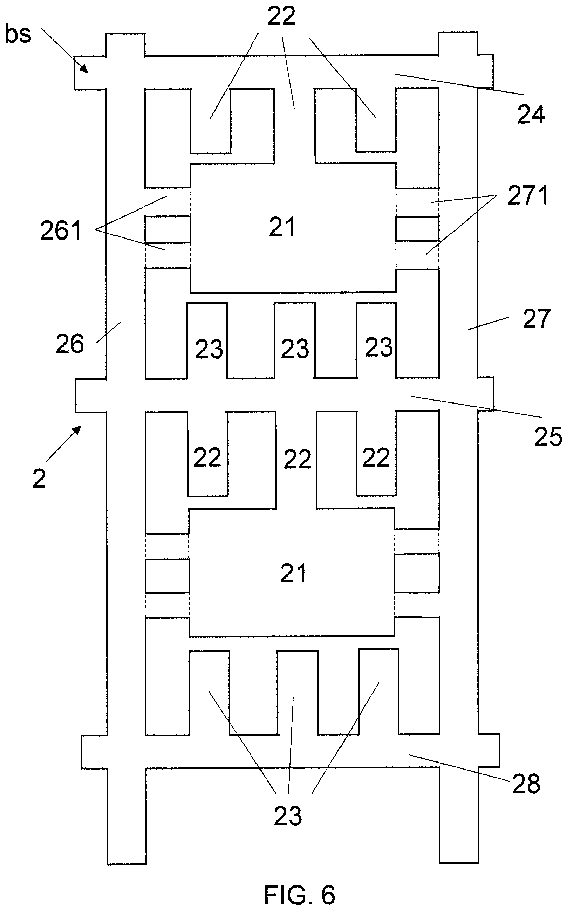

Figures 6 to 10 illustrate steps of a method for manufacturing multiple semiconductor packages in common manufacturing steps, according to an embodiment of the present invention. Although in the present example, the leadframe 2 comprises only two platforms in form of die pads 21 supporting two semiconductor packages, it is understood, that in real manufacturing the leadframe 2 may contain many more platforms, e.g. for supporting tens or hundreds of semiconductor packages.

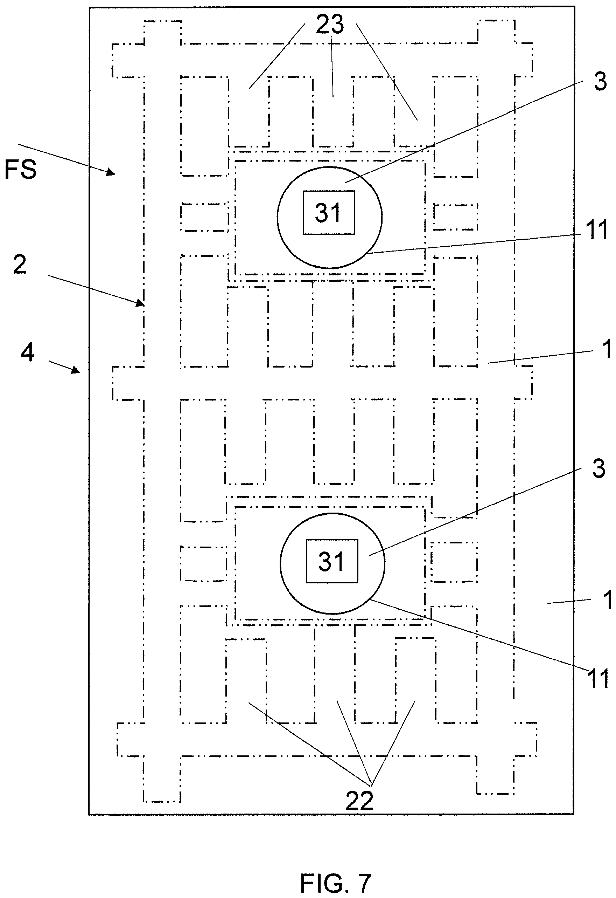

Accordingly, the leadframe 2 of Figure 6, which again illustrates a view on its back side bs, basically is a duplication of the leadframe of Figure 1, except that the support lead 25 now serves as support lead for the contact pads 23 of the upper package to be built, and at the same time as support lead for the contact pads 22 of the lower package to be built. The support lead for the contact pads 23 of the lower package is referred to as 28. The support leads 26 and 27 are common support leads for both die pads 21 and may also serve as common support leads for further die pads arranged next to the support leads 26 and 27 on the other sides, if any. Corresponding to Figure 2 but presently not shown, semiconductor chips 3 are attached to both die pads 21 at their front side fs opposite the back side bs shown, and each semiconductor chip 3 is electrically connected to the associate contact pads 22 and 23. In a next step, this arrangement is inserted into a mold subsequently filled by a mold compound. Figure 7 illustrates the result after having removed the mold: In the encapsulated leadframe assembly 4 in a top view, i.e. in a view onto its front side FS, the mold compound encapsulates the corresponding semiconductor chips 3 except for an opening 11 each which provides access to a portion of the semiconductor chip 3 e.g. containing the sensing element 31. The encapsulation 1 provides mechanical stability and protects the semiconductor chips 3. The encapsulation 1 is made from insulating material, such as an epoxy based polymer containing filler particles such as glass, specifically SiO₂. As can be seen from Figure 7, the encapsulation 1 extends over the leadframe 2 as a common continuous encapsulation 1 over all semiconductor chips 3 except for the openings 11. The leadframe 2 and the semiconductor chips 3 partly covered by the encapsulation 1 are illustrated in a phantom view.

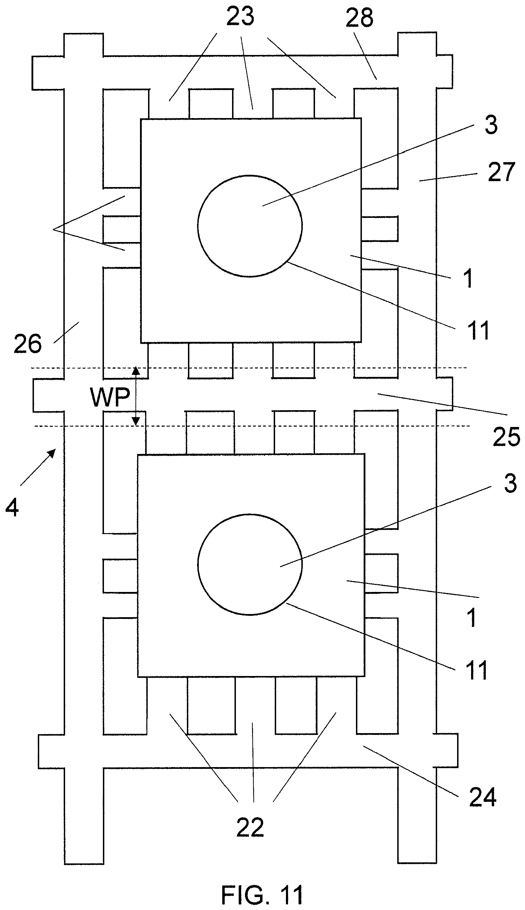

In a different embodiment as shown in Figure 11, individual encapsulations 1 per package are built which encapsulations 1 are disconnected from each other. For manufacturing these blocks, the mold 4 has a different shape than for producing the encapsulation 1 of Figure 7.

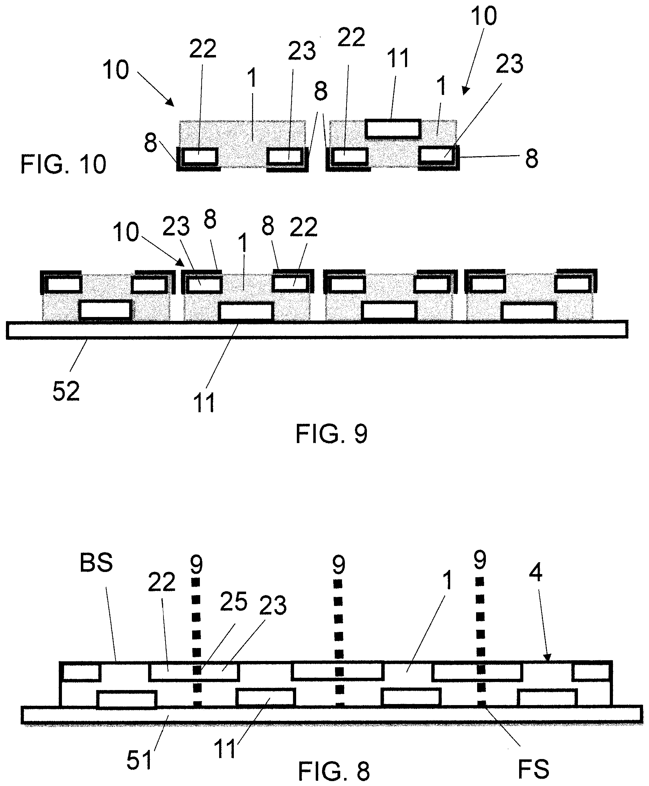

In the embodiment of Figure 7, the resulting encapsulated leadframe assembly 4 is arranged on a dicing tape 5, e.g. by gluing, see the cut view shown in Figure 8. Specifically, the encapsulated leadframe assembly 4 is arranged on the dicing tape 51 with its front side FS facing the dicing tape 51. The dicing tape 51 is known as a support during singulation of semiconductor chips or packages. The front side FS of the encapsulated leadframe assembly 4 in this embodiment comprises access openings 11. Presently, the access openings 11 face the dicing tape 51 which serves for protecting the semiconductor chips and their sensing elements during the subsequent separating and plating steps. Accordingly, the back side BS of the encapsulated leadframe assembly 4 including the exposed back sides of the contact pads 22, 23 faces away from the dicing tape 51. In the present state, contact pads 22 and 23 of adjacent semiconductor packages are still connected, via a common support lead 25 such that contact pads 22 and 23 and support lead 25 presently form a single piece of the leadframe.

For separating the semiconductor packages 10 from each other, and specifically for dicing the encapsulated leadframe assembly 4 into the multiple semiconductor packages 10, a separation or dicing tool such as a saw is applied from the back side BS as is suggested by sawing paths 9. In the present example, the separation tool saws through both, the leadframe 2 in form of the 22, 23, 25 lead portion, and the encapsulation 1. However, the dicing tool preferably stops after having diced a little into the dicing tape 5 still providing a stable support.

After dicing, the semiconductor packages 10 are separated from each other, see Figure 9, also under the assumption that further cutting paths orthogonal to the presently shown cutting paths 9 are cut in order to separate adjacent semiconductor packages 10 also in the other dimension. However, the individual semiconductor packages 10 are attached to the dicing tape 51, or for illustrative purpose only may be attached to a different support 52, such as shown in Fig. 9.

This very arrangement of Fig. 9 is electroless plated by immersion into a bath. First, the arrangement is immersed into a bath comprising silver ions for plating a silver coating onto the back sides bs and side faces sf of the individual semiconductor packages 10, while in a second step, such plated arrangement is immersed into a bath comprising gold ions for plating a gold coating on top of the silver coating. Figure 9 shows the arrangement after plating.

In case of the illustrative example of Figure 11, it is only the leadframe that is punched or diced, but not the encapsulation 1 which lacks between adjacent packages 10. In such embodiment, the separation of the semiconductor packages may be achieved by punching the leadframe 2 between the encapsulations 1 of two adjacent packages. In this example, the punch may have a width WP so as to remove the support lead 25 and desired portions of the contact pads 22 and 23 between the encapsulations 1. The punching tool may be applied from a front side of the encapsulated leadframe assembly 4 as is shown in the top view of FIG. 11. After punching, it is preferred that the individual semiconductor packages 10 are mounted to a support 52 with the front side facing the support such as shown in FIG 9. Such assembly then may be immersed into the various baths for plating.

Finally, the individual semiconductor packages 10 with now plated contact pads 22, 23 are picked from the support 52. In Fig. 10, two different semiconductor packages 10 are shown, the left one without an access opening for illustrative purpose only, the right one including an access opening 11. Any surfaces of the leadframe generated by way of dicing or punching in the singulation step, and any other surfaces of the leadframe exposed from the encapsulation now are covered by a combined silver-gold plating 8.

## Claims

1. Method for manufacturing multiple semiconductor packages (10), comprising the steps of
- providing an electrically conducting leadframe (2) including a front side (fs) and a back side (bs),
wherein the leadframe (2) comprises
- multiple die pads (21),
- at least one set of contact pads (22,23) per die pad (21), and
- a support lead (25) connected to the sets of contact pads (22,23) assigned to adjacent die pads (21),
- mounting a semiconductor chip (3) on the front side (fs) of each die pad (21) resulting in a leadframe assembly (4),
- at least partially encapsulating the leadframe assembly (4), thereby exposing at least the back sides (bs) of the contact pads (22) from the encapsulation (1),
wherein the encapsulation (1) is generated by arranging the leadframe assembly (4) in a mold, and
wherein a mold compound is applied into the mold thereby at least partially encapsulating the semiconductor chip (3) and partially encapsulating the leadframe (2),
wherein each semiconductor chip (3) is a sensor chip, wherein the mold comprises a protrusion per sensor chip, wherein the leadframe assembly (4) is arranged in the mold with each protrusion facing a sensing element of the assigned sensor chip or facing an area on the sensor chip reserved for allocating a sensing element, each protrusion resulting in an access opening (11) in the encapsulation (1) for the sensing element,
- arranging the encapsulated leadframe assembly (4) on a dicing tape (51)
with a front side (FS) facing the dicing tape (51) and a back side (BS) including the exposed back sides (bs) of the contact pads (22) facing away from the dicing tape (51)
and with the encapsulation (1) and the access opening (11) facing the dicing tape (51),
- separating the support leads (25) from the connected contact pads (22), thereby generating semiconductor packages (10) comprising an exposed side face (sf) of each contact pad (22),
- applying an electroless immersion plating process to the semiconductor packages (10) by immersing the singulated semiconductor packages (10) into a bath comprising silver ions resulting in a silver plating (81) on at least the back side (bs) and the side face (sf) of each contact pad (22) and subsequently immersing the resulting semiconductor packages (10) into a bath comprising gold ions resulting in a gold plating (82) on top of the silver plating (81),
wherein the electroless immersion plating process is applied to the semiconductor packages (10) when residing on the dicing tape (51).

2. Method according to claim 1, for manufacturing multiple semiconductor packages (10),
wherein the sets of contact pads (22,23) assigned to adjacent die pads (21) connect to the support lead (25) from opposite sides.

3. Method according to any of the preceding claims,
wherein the support leads (25) are separated from the connected contact pads (22) by applying a separation tool to the back side (BS) of the encapsulated leadframe assembly (4).

4. Method according to claim 3,
wherein the encapsulated leadframe assembly (4) is sawed down to at least the dicing tape (51) thereby separating the semiconductor packages (10) previously connected by the leadframe (2) and the encapsulation (1).

5. Method according to claim 4,
wherein the separated semiconductor packages (10) are picked from the dicing tape (51) and are arranged on a support (52).

6. Method according to claim 1 or 2,
wherein the leadframe assembly (4) is partially encapsulated, thereby exposing the support leads (25) from the encapsulation (1),
wherein the support leads (25) are separated from the connected contact pads (22,23) by applying a punching tool thereby separating the semiconductor packages (10) previously connected by the leadframe (2),
wherein the separated semiconductor packages (10) are arranged on a support (52).

7. Method according to any of the preceding claims,
wherein at least one of the semiconductor packages (10) is placed on a carrier (6),
wherein contact material (7) is applied between at least one, and preferably all, of the contact pads (22, 23) of the semiconductor package (10) and corresponding metallizations of the carrier (6) in order to generate an electrical contact (71) there between,
wherein each electrical contact (71) is optically inspected by automated optical inspection (OI).

8. Method according to claim 7,
wherein each electrical contact (71) is optically inspected by the automated optical inspection (OI) applied from top of the semiconductor package (10).

9. Method according to any one of the preceding claims,
wherein separating the or each support lead (24,25) includes sawing or punching each support lead (24,25) by means of a blade or a punching tool of a width exceeding a width of the support lead (24,25) resulting in a removal of the support lead (24,25).

## Patentansprüche

1. Verfahren zur Herstellung von mehreren Halbleiterpaketen (10), das die folgenden Schritte umfasst
- Bereitstellen eines elektrisch leitenden Leiterrahmens (2) mit einer Vorderseite (fs) und einer Rückseite (bs),
wobei der Leiterrahmen (2) umfasst
- mehrere Die-Pads (21),
- mindestens einen Satz von Kontaktpads (22, 23) pro Die-Pad (21), und
- einen Trägerleiter (25), der mit den Sätzen von Kontaktpads (22, 23) verbunden ist, die benachbarten Die-Pads (21) zugeordnet sind,
- Anbringen eines Halbleiterchips (3) auf der Vorderseite (fs) jedes Die-Pads (21), was zu einer Leiterrahmen-Anordnung (4) führt,
- zumindest teilweises Verkapseln der Leiterrahmen-Anordnung (4), wodurch zumindest die Rückseiten (bs) der Kontaktpads (22) von der Verkapselung (1) frei liegen,
wobei die Verkapselung (1) durch Anordnen der Leiterrahmen-Anordnung (4) in einer Form erzeugt wird, und
wobei eine Formmasse in die Form eingebracht wird, wodurch der Halbleiterchip (3) zumindest teilweise eingekapselt und der Leiterrahmen (2) teilweise eingekapselt wird,
wobei jeder Halbleiterchip (3) ein Sensorchip ist, wobei die Form einen Vorsprung pro Sensorchip aufweist, wobei die Leiterrahmen-Anordnung (4) in der Form so angeordnet ist, dass jeder Vorsprung einem Sensorelement des zugeordneten Sensorchips zugewandt ist oder einem Bereich auf dem Sensorchip zugewandt ist, der für die Zuordnung eines Sensorelements vorgesehen ist, wobei jeder Vorsprung zu einer Zugangsöffnung (11) in der Verkapselung (1) für das Sensorelement führt,
- Anordnen der eingekapselten Leiterrahmen-Anordnung (4) auf einem Dicing-Tape (51)
mit einer Vorderseite (FS), die dem Dicing-Tape (51) zugewandt ist, und einer Rückseite (BS), die die freiliegenden Rückseiten (bs) der Kontaktpads (22) enthält, die von dem Dicing-Tape (51) abgewandt sind,
und wobei die Verkapselung (1) und die Zugangsöffnung (11) dem Dicing-Tape (51) zugewandt sind,
- Trennen der Trägerleiter (25) von den verbundenen Kontaktpads (22), wodurch Halbleiterpakete (10) mit einer freiliegenden Seitenfläche (sf) jedes Kontaktpads (22) erzeugt werden,
- Anwenden eines stromlosen Tauchplattierungsverfahrens auf die Halbleiterpakete (10) durch Eintauchen der vereinzelten Halbleiterpakete (10) in ein Bad, das Silberionen enthält, was zu einer Silberplattierung (81) auf zumindest der Rückseite (bs) und der Seitenfläche (sf) jedes Kontaktpads (22) führt, und anschliessendes Eintauchen der resultierenden Halbleiterpakete (10) in ein Bad, das Goldionen enthält, was zu einer Goldplattierung (82) auf der Silberplattierung (81) führt,
wobei das stromlose Tauchplattierungsverfahren auf die Halbleiterpakete (10) angewendet wird, wenn sie sich auf dem Dicing-Tape (51) befinden.

2. Verfahren nach Anspruch 1, zur Herstellung von mehreren Halbleiterpaketen (10),
wobei die Sätze von Kontaktpads (22, 23), die benachbarten Die-Pads (21) zugeordnet sind, von gegenüberliegenden Seiten mit dem Trägerleiter (25) verbunden sind.

3. Verfahren nach einem der vorhergehenden Ansprüche,
wobei die Trägerleiter (25) von den verbundenen Kontaktpads (22) getrennt werden, indem ein Trennwerkzeug auf der Rückseite (BS) der eingekapselten Leiterrahmen-Anordnung (4) angewendet wird.

4. Verfahren nach Anspruch 3,
wobei die eingekapselte Leiterrahmen-Anordnung (4) zumindest bis zum Dicing-Tape (51) durchgesägt wird, wodurch die zuvor durch den Leiterrahmen (2) und die Verkapselung (1) verbundenen Halbleiterpakete (10) getrennt werden.

5. Verfahren nach Anspruch 4,
wobei die getrennten Halbleiterpakete (10) von dem Dicing-Tape (51) abgenommen und auf einer Unterlage (52) angeordnet werden.

6. Verfahren nach Anspruch 1 oder 2,
wobei die Leiterrahmen-Anordnung (4) teilweise verkapselt wird, wodurch die Trägerleiter (25) von der Verkapselung (1) freigelegt werden,
wobei die Trägerleiter (25) von den verbundenen Kontaktpads (22, 23) durch Anwendung eines Stanzwerkzeugs getrennt werden, wodurch die zuvor durch den Leiterrahmen (2) verbundenen Halbleiterpakete (10) getrennt werden,
wobei die getrennten Halbleiterpakete (10) auf einer Unterlage (52) angeordnet werden.

7. Verfahren nach einem der vorhergehenden Ansprüche,
wobei mindestens eines der Halbleiterpakete (10) auf einem Träger (6) angeordnet wird,
wobei Kontaktmaterial (7) zwischen mindestens einem, vorzugsweise allen, der Kontaktpads (22, 23) des Halbleiterpakets (10) und entsprechenden Metallisierungen des Trägers (6) aufgebracht wird, um einen elektrischen Kontakt (71) zwischen ihnen zu erzeugen,
wobei jeder elektrische Kontakt (71) durch automatisierte optische Inspektion (OI) optisch geprüft wird.

8. Verfahren nach Anspruch 7,
wobei jeder elektrische Kontakt (71) durch die automatisierte optische Inspektion (OI) von der Oberseite des Halbleiterpakets (10) her optisch inspiziert wird.

9. Verfahren nach einem der vorhergehenden Ansprüche,
wobei das Trennen des oder jedes Trägerleiters (24, 25) das Sägen oder Stanzen jedes Trägerleiters (24, 25) mittels einer Klinge oder eines Stanzwerkzeuges mit einer Breite umfasst, die eine Breite des Trägerleiters (24, 25) übertrifft, was zu einer Entfernung des Trägerleiters (24, 25) führt.

## Revendications

1. Procédé de fabrication d'une pluralité de boîtiers de semi-conducteurs (10) comprenant les étapes suivantes
- fournir une grille de connexion électriquement conductrice (2) ayant une face avant (fs) et une face arrière (bs),
la grille de connexion(2) comprenant
- une pluralité de patins de matrice (21),
- au moins un ensemble de patins de contact (22, 23) par patin de matrice (21), et
- un conducteur porteur (25) connecté aux ensembles de patins de contact (22, 23) associés à des patins de matrice adjacents (21),
- monter une puce semi-conductrice (3) sur la face avant (fs) de chaque patin de matrice (21), ce qui donne un ensemble de grille de connexion (4),
- encapsuler au moins partiellement l'ensemble de grille de connexion (4), de sorte qu'au moins les faces arrière (bs) des patins de contact (22) sont exposées à partir de l'encapsulation (1),
dans lequel l'encapsulation (1) est produite en plaçant l'ensemble de grille de connexion (4) dans un moule, et
dans lequel un composé de moulage est introduit dans le moule, encapsulant ainsi au moins partiellement la puce semi-conductrice (3) et encapsulant partiellement la grille de connexion (2),
dans lequel chaque puce semi-conductrice (3) est une puce de capteur, le moule ayant une protubérance par puce de capteur, l'ensemble de grille de connexion (4) étant disposé dans le moule de telle sorte que chaque protubérance fait face à un élément de capteur de la puce de capteur associée ou fait face à une zone sur la puce de capteur destinée à l'association d'un élément de capteur, chaque protubérance menant à une ouverture d'accès (11) dans l'encapsulation (1) pour l'élément de capteur,
- disposer l'assemblage de grille de connexion encapsulée (4) sur une bande de découpage (51) ayant un côté avant (FS) faisant face à la bande de découpage (51) et un côté arrière (BS) comprenant les côtés arrière exposés (bs) des patins de contact (22) faisant face à l'opposé de la bande de découpage (51)
et dans lequel l'encapsulation (1) et l'ouverture d'accès (11) font face à la bande de découpage (51),
- séparer les conducteurs porteurs (25) des patins de contact liées (22), créant ainsi des boîtiers de semi-conducteurs (10) avec une surface latérale exposée (sf) de chaque patin de contact (22),
- appliquer un procédé de placage par immersion sans courant aux boîtiers de semi-conducteurs (10) en immergeant les boîtiers de semi-conducteurs séparés (10) dans un bain contenant des ions argent, ce qui donne lieu à un placage d'argent (81) sur au moins la face arrière (bs) et la face latérale (sf) de chaque patin de contact (22), et ensuite par immersion des boîtiers de semi-conducteurs résultants (10) dans un bain contenant des ions or, ce qui donne lieu à un placage d'or (82) sur le placage d'argent (81),
dans lequel le procédé de placage par immersion sans courant est appliqué aux boîtiers de semi-conducteurs (10) lorsqu'ils sont sur la bande de découpage (51).

2. Procédé selon la revendication 1, pour fabriquer une pluralité de boîtiers de semi-conducteurs (10),
dans lequel les ensembles de patins de contact (22, 23) associés à des patins de matrice adjacents (21) sont connectés par des côtés opposés au conducteur porteur (25).

3. Procédé selon l'une des revendications précédentes,
dans lequel les conducteurs porteurs (25) sont séparés des patins de contact connectées (22) en appliquant un outil de séparation sur le côté arrière (BS) de l'ensemble de grille de connexion encapsulé (4).

4. Procédé selon la revendication 3,
dans lequel l'ensemble de grille de connexion encapsulé (4) est scié au moins jusqu'à la bande de découpage (51), séparant ainsi les boîtiers de semi-conducteurs (10) précédemment reliés par la grille de connexion (2) et l'encapsulation (1).

5. Procédé selon la revendication 4,
dans lequel les boîtiers de semi-conducteurs séparés (10) sont retirés de la bande de découpage (51) et disposés sur un support (52).

6. Procédé selon la revendication 1 ou 2,
dans lequel l'ensemble de grille de connexion (4) est partiellement encapsulé, exposant ainsi les conducteurs porteurs (25) à partir de l'encapsulation (1),
dans lequel les conducteurs porteurs (25) sont séparés des patins de contact interconnectées (22, 23) par l'application d'un outil de poinçonnage, séparant ainsi les boîtiers de semi-conducteurs (10) précédemment interconnectés par la grille de connexion (2),
dans lequel les boîtiers de semi-conducteurs séparés (10) sont placés sur un support (52).

7. Procédé selon l'une des revendications précédentes,
dans lequel au moins un des boîtiers de semi-conducteurs (10) est disposé sur un support (6),
dans lequel un matériau de contact (7) est appliqué entre au moins une, de préférence toutes, les patins de contact (22, 23) du boîtier de semi-conducteurs (10) et les métallisations correspondantes du support (6) pour créer un contact électrique (71) entre elles,
dans lequel chaque contact électrique (71) est inspecté optiquement par une inspection optique automatisée (OI).

8. Procédé selon la revendication 7,
dans lequel chaque contact électrique (71) est inspecté optiquement par l'inspection optique automatisée (OI) depuis le côté supérieur du boîtier de semi-conducteurs (10).

9. Procédé selon l'une des revendications précédentes,
dans lequel la séparation du ou de chaque conducteur porteur (24, 25) comprend le sciage ou le poinçonnage de chaque conducteur porteur (24, 25) au moyen d'une lame ou d'un outil de poinçonnage ayant une largeur dépassant une largeur du conducteur porteur (24, 25), ce qui entraîne un retrait du conducteur porteur (24, 25).
(24, 25).
